**Europäisches Patentamt**

**European Patent Office**

**Office européen des brevets**

(11) Numéro de publication: **0 176 378**
**B1**

(12) **FASCICULE DE BREVET EUROPEEN**

(45) Date de publication du fascicule du brevet:
**08.11.89**

(21) Numéro de dépôt: **85401552.6**

(22) Date de dépôt: **30.07.85**

(51) Int. Cl.⁴: **C 08 J 5/24, C 08 L 61/06,
C 08 K 3/38 // C08L61:06,
C08K3:38**

(54) Nouvelles compositions de résines phénoliques.

(30) Priorité: **03.08.84 FR 8412277**

(43) Date de publication de la demande:
**02.04.86 Bulletin 86/14**

(45) Mention de la délivrance du brevet:
**08.11.89 Bulletin 89/45**

(84) Etats contractants désignés:
**AT BE CH DE GB IT LI LU NL SE**

(56) Documents cités:
**BE-A- 676 219**

**CHEMICAL ABSTRACTS, vol. 80, 28 janvier 1974, page
65, no. 16058n, Columbus, Ohio, US; & JP - A - 73 04 954
(TOKYO SHIBAURA ELECTRIC CO. LTD.) 13-02-1973
CHEMICAL ABSTRACTS, vol. 96, 22 fevrier 1982, page
312, no. 56972t, Columbus, Ohio, US; & JP - A - 81 133
154 (IG-TECHNICAL RESEARCH INC.) 19-10-1981
PATENTS ABSTRACTS OF JAPAN, vol. 8, no. 110, 23 mai
1984, page 68 C 224; & JP - A - 59 24 772 (NISSHIN
BOSEKI K.K.) 08-02-1984**

(73) Titulaire: **NORSOLOR S.A., Tour Aurore Place des
Reflets, F-92080 Paris la Défense Cédex 5 (FR)**

(72) Inventeur: **Cousin, Michel, 81, bld Wattiez,
F-62218 Loison sous Lens (FR)**
Inventeur: **Meyer, Nicolas, 12, rue des Déportés,
F-62300 Lens (FR)**
Inventeur: **Boinot, François, 54, rue Henri Martin,
F-62800 Lievin (FR)**
Inventeur: **Hochin, André, 19, rue Hermant,
F-62700 Bruay en Artols (FR)**

(74) Mandataire: **Rieux, Michel, c/o NORSOLOR Service
Propriété Industrielle B.P. 57, F-62670 Mazingarbe (FR)**

## Description

La présente invention concerne de nouvelles compositions de résines phénoliques, elle a plus particulièrement pour objet des compositions de résines phénoliques particulièrement adaptées pour la fabrication de «mats préimprégnés phénoliques».

Les préimprégnés sont des matériaux mixtes que l'on prépare à partir de résines thermodurcissables et de renforts et éventuellement de charges. Le renfort utilisé est à l'état de fibres telles que fibres cellulosiques ou fibres de verre en particulier rovings de fibres de verre, de non-tissé par exemple en polyester de haut poids moléculaire, en chlorure de polyvinyle, de mat de fibres de verre ou tissu par exemple en polyamide aromatique, en verre ou en amiante. Ces matériaux préimprégnés présentent l'avantage de pouvoir être moulés directement à la presse sans qu'il soit nécessaire de préparer au préalable un mélange constitué de résine, de catalyseurs, de charges et de pigments. Les préimprégnés peuvent être divisés en deux catégories: d'une part, les préimprégnés «dits sans fluage», et d'autre part, les préimprégnés «dits avec fluage». Les préimprégnés «sans fluage» sont généralement constitués uniquement par des renforts de fibres de verre imprégnés d'une résine convenable conduite à un stade approprié de polymérisation partielle, stade dit «B». A ce stade-là, les résines ne poissent pratiquement plus mais sont encore solubles et fusibles. Un tel matériau mixte mis sous presse chauffée permet un déplacement de la résine entre les fibres et conduit à une distribution uniforme du verre et de la résine. Après fermeture du moule, la résine est complètement durcie. On fabrique les préimprégnés sans fluage à partir de résines époxy, de résines formophénoliques et aussi de résines polyesters à base de diallyl phtalate. De tels matériaux permettent des applications particulièrement limitées car ils présentent le plus souvent l'inconvénient de se désolidariser lors de la mise en œuvre: ils sont par exemple utilisés pour la fabrication de circuits imprimés.

Les préimprégnés «à fluage» connus appelés le plus souvent «mats préimprégnés» sont jusqu'à présent préparés uniquement à partir d'une seule catégorie de résines à savoir les résines polyesters. Suivant la technique de fabrication mise en œuvre, on distingue en particulier deux variétés de «mats préimprégnés».

Les pré-imprégnés SMC (en anglais sheet molding compound) sont des matériaux mixtes constitués d'une nappe de fils de verre coupés, préimprégnée de résine chargée, pigmentée et catalysée. Ils se présentent entre deux pellicules filmogènes (par exemple polyéthylène) ce qui permet une manipulation aisée. Ils sont ensuite mis en œuvre par moulage par compression.

Les composés de moulage dans la masse (en anglais bulk moulding compound: BMC) sont des mélanges constitués de résine thermodurcissable, de charge et de fils de verre coupés: ils se présentent en vrac ou en boudin prêt à l'emploi.

Le mat préimprégné ainsi obtenu présente après mûrissement à la chaleur une consistance voisine de celle du cuir ou d'une toile cirée. Après stockage dans une chambre de mûrissement le mat préimprégné ainsi obtenu peut être stocké pendant environ trois mois, période durant laquelle il peut être utilisé par moulage à chaud et sous pression.

La difficulté majeure qui doit être surmontée pour fabriquer ces mats préimprégnés à base de résines polyester est de disposer de résine qui soit assez fluide pour pouvoir imprégner le tapis de fils de verre coupés mais dont l'évolution de la viscosité durant les premières 48 heures (période au bout de laquelle la viscosité ne doit pratiquement plus varier à température ambiante) soit assez rapide afin de pouvoir obtenir un mat préimprégné qui présente la consistance désirée et qui doit être voisine de celle du cuir ou de celle d'une toile cirée comme indiqué ci-dessus. On voit donc qu'il existe pratiquement deux problèmes antagonistes à résoudre. Pour résoudre de tels problèmes, il est connu d'ajouter à la résine polyester un épaississant choisi parmi des oxydes d'alcalinoterreux tel que l'oxyde de magnésium. L'addition d'un tel composé à la résine polyester permet d'obtenir une résine présentant une viscosité souhaitée mais aussi une stabilité suffisante qui permet à la résine de ne pas épaissir trop rapidement sous peine d'obtenir une imprégnation médiocre des tapis de fils de verre coupés.

On aurait pu penser que la simple transposition des oxydes d'alcalino-terreux utilisés pour les résines polyester aux résines phénoliques aurait permis d'obtenir des compositions pâteuses de résines phénoliques convenant pour la fabrication de mats préimprégnés phénoliques. Malheureusement, il n'en est rien. On constate en effet que l'addition d'oxyde d'alcalino-terreux aux résines phénoliques conduit à des compositions résineuses qui ne sont pas homogènes, constituées en particulier d'une croûte en surface et de cristaux d'oxyde alcalino-terreux dans la composition. Par ailleurs, l'utilisation d'oxyde alcalino-terreux seul dans les résines phénoliques conduit à une réaction exothermique qui peut être responsable d'une décomposition du catalyseur de durcissement. De plus la mise en œuvre d'oxyde alcalinoterreux conduit à des formulations qui demandent des temps de moulage rédhibitoires (2 minutes environ par mm) en raison d'une inhibition causée par cet oxyde.

Il est connu de mettre en œuvre des dérivés borés dans les résines phénoliques. On a décrit en particulier (voir brevet belge 676 219) des compositions constituées de résines phénoliques additionnées d'anhydride borique, d'acides boriques, de sels d'acides boriques ou d'esters boriques aromatiques et de résines naturelles à base de colophane. Ces compositions sont utilisées pour fabriquer des articles moulés ayant des propriétés au feu améliorées.

La présente invention concerne des compositions de résines phénoliques convenant pour la fabrication de mats préimprégnés phénoliques selon lesquelles les compositions utilisées pour l'imprégnation des mats de fils sont constituées de résines formo-phénoliques du type résols, de charges, de pigments et d'agents durcisseurs, caractérisées en ce que ces compositions contiennent un additif constitué d'au moins 20% en poids par rapport au poids total de l'additif, d'un métaborate alcalin ou alcalino-terreux, l'additif étant mis en œuvre en quantité au moins égale à 5% et au plus égale à 60% en poids par rapport au poids de la solution de résine phénolique.

Selon l'invention le métaborate alcalin ou alcalino-terreux est mis en œuvre avec un oxyde alcalino-terreux: cet oxyde étant utilisé en quantité au plus égale à 80% en poids par rapport au poids total de l'additif.

On a en effet trouvé que la mise en œuvre d'un tel additif permet d'obtenir une composition résineuse homogène, une composition dont la viscosité évolue durant les premières quarante-huit heures pour se stabiliser ensuite. On obtient ainsi une composition douée de propriétés telles qu'elle permet la fabrication de mats préimprégnés.

Selon une des caractéristiques des compositions de l'invention la quantité d'additif mise en œuvre est égale au plus à 60% en poids par rapport au poids de la solution de résine phénoli-. que mise en œuvre et de préférence entre 5 et 40% en poids. En dessous de 5% on n'observe pratiquement aucune incidence sur la viscosité de la composition; au-delà de 60% en poids il n'est plus possible de maîtriser la viscosité de la composition ce qui la rend inadaptée pour la fabrication de mats préimprégnés.

Les compositions objet de l'invention sont constituées de résine phénolique et d'un additif constitué d'au moins 20% en poids par rapport au poids total de l'additif, d'un métaborate alcalin ou alcalino-terreux.

Selon l'invention le métaborate alcalin ou alcalino-terreux est mis en œuvre avec un oxyde alcalino-terreux: cet oxyde étant utilisé en quantité au plus égale à 80% en poids par rapport au poids total de l'additif. Suivant les caractéristiques des résines phénoliques mises en œuvre on adapte la composition de l'additif qui peut contenir jusqu'à 100% en poids de métaborate alcalin ou alcalino-terreux, mais toujours au moins 20% en poids de métaborate alcalin ou alcalino-terreux.

Les métaborates alcalins ou alcalino-terreux utilisés pour l'obtention des compositions de résines phénoliques objet de l'invention, sont choisis de préférence parmi les métaborates de lithium ou de calcium ou de baryum. Pour des raisons de disponibilité et des facilités d'obtention on utilise préférentiellement le sel de baryum. Parmi les oxydes alcalino-terreux mis en œuvre on choisit de préférence l'oxyde de magnésium.

Les compositions de résines, objet de l'invention sont préparées en ajoutant l'additif à la résine phénolique. De préférence, pour des raisons de stabilité et de facilité de dispersion, on ajoute l'additif à la solution de catalyseur, le mélange obtenu étant ensuite additionné à la résine phénolique.

De façon connue, le durcissement des résines phénoliques est réalisé à l'aide de solutions de catalyseurs constituées de solvant et d'un acide: comme acide on peut citer en particulier l'acide paratoluène sulfonique, l'acide orthotoluène sulfonique, l'acide benzène sulfonique et l'acide xylène sulfonique. Comme solvants organiques, on entend les composés à fonctions alcool: méthanol, éthanol, propanol, isopropanol, ainsi que les polyols comme le glycérol, le dipropylène-glycol et le triéthylène-glycol. Les catalyseurs latents connus conviennent plus particulièrement pour la fabrication des compositions conformes à l'invention. Par catalyseurs latents, on entend des catalyseurs qui sont pratiquement inactifs à basse température, mais qui deviennent catalytiquement actifs à température élevée, nécessaire à la polycondensation de la résine. Comme catalyseurs latents, on peut citer par exemple les solutions constituées d'un ester alcoylé, d'un acide toluène sulfonique, d'un solvant organique et d'un acide toluène sulfonique ou d'acide sulfurique concentré. Les quantités de durcisseurs utilisées sont celles employées classiquement pour le durcissement de résols: ces quantités sont comprises entre 5 et 50% en poids par rapport au poids de la solution de résol et de préférence entre 10 et 40%.

Les résols utilisés pour la fabrication des compositions conformes à l'invention sont des résols connus préparés par condensation de formol sur le phénol en présence d'un catalyseur alcalin. Ils présentent un rapport molaire F/P compris entre 1,2 et 2,5 et contiennent éventuellement des additifs tels que plastifiants, tensio-actifs, charges telles que silice, kaolin, hydroxyde d'aluminium.

Les compositions de résines phénoliques objet de l'invention conviennent particulièrement pour la fabrication de mats préimprégnés phénoliques. Pour la fabrication des préimprégnés, on utilise de façon connue des renforts constitués des fils coupés en fibres de verre, des rovings de fils de verre coupés, des tissus de polyamide, des fibres cellulosiques ou des fibres de carbone. La quantité de fibres utilisée est telle que le mat préimprégné fini en contient au plus 70% en poids par rapport au poids total du matériau fini.

Les compositions de résines phénoliques objet de l'invention, permettent de fabriquer des mats préimprégnés à très bon fluage, elles permettent également d'obtenir des mats préimprégnés phénoliques qui peuvent être stockés pendant au moins 2 mois avant moulage à température ambiante. Par rapport aux mats préimprégnés connus fabriqués à partir de résines polyester insaturé, les mats préimprégnés phénoliques ont l'avantage de présenter de meilleures résistances au feu, à la combustion, ce qui élargit leurs champs d'application. De plus, le matériau fini à une meilleure tenue thermique.

Les mats préimprégnés obtenus à partir des compositions de résine objet de l'invention peuvent être mis en œuvre après stockage, de façon connue, en les soumettant par exemple dans des presses à des pressions comprises entre 40 et 140 bars pendant 20 à 80 secondes par millimètre d'épaisseur à une température comprise entre 110 et 150 °C.

Les exemples suivants illustrent la présente invention. Les viscosités sont déterminées à 20 °C.

Les exemples portent sur des mesures de viscosité:

– avec des résines phénoliques seules

– avec des résines phénoliques contenant un catalyseur de durcissement utilisé de façon classique pour la mise en œuvre de ces résines.

– avec des résines phénoliques additionnées d'un catalyseur de durcissement, de charges et de fibres de verre.

EXEMPLE 1

On utilise 100 parties en poids d'une résine phénolique qui présente les caractéristiques suivantes

– rapport molaire $F/P = 1,5$

– extrait sec: 72% (déterminée sur 4 grammes de produit dans une étuve réglée à 140 °C pendant 3 heures)

– réactivité de 80 °C (déterminée selon une méthode qui consiste à mesurer le pic exothermique d'une résine additionnée de 10% d'acide sulfurique et d'éthanol).

– viscosité à 25 °C: 0,5 Pa.s

On ajoute à cette résine 13,3 parties de métaborate de baryum de formule $BaB_2O_4, H_2O$ à température ambiante. On obtient une composition fine homogène qui après épaississement reste homogène. Au bout de 10 minutes la viscosité de la composition s'élève à 15 Pa.s

Au bout de 30 minutes la viscosité est de 300 Pa.s

Au bout d'une heure elle est de 1000 Pa.s

Au bout de 22 heures elle se stabilise à 2000 Pa.s

EXEMPLE 2 (comparaison)

On met en œuvre 100 parties de la résine de l'exemple 1 et respectivement 8,5 et 10,5 parties d'oxyde de magnésium qui est un épaississant connu des résines polyesters. Aux deux mélanges obtenus, on ajoute 26,67 parties d'un catalyseur de durcissement constitué d'un mélange de méthanol et d'acide paratoluène sulfonique: ce catalyseur est fabriqué à partir d'une mole de méthanol et d'une mole d'acide paratoluène sulfonique.

On constate en premier que la dispersion est difficile à réaliser et l'on obtient une composition constituée d'une croûte en surface.

Avec 8,5 parties on obtient les résultats suivants:

Au bout de 30 minutes, la viscosité du mélange est de 2000 Pa.s

Au bout d'une heure elle est de 1000 Pa.s

Au bout de 22 heures elle n'est que de 1100 Pa.s

Au bout de 10 jours elle est de 30 000 Pa.s

Avec 10,5 parties d'oxyde de magnésium on relève les résultats suivants. Au bout de 30 minutes la viscosité est de 270 000 Pa.s

Au bout d'une heure elle n'est plus mesurable.

EXEMPLE 3

L'exemple 1 est répété mais en mettant en œuvre 13,3 parties d'un additif constitué de proportions variables de métaborate alcalin et d'oxyde de magnésium. Le tableau 1 suivant indique la viscosité du mélange obtenu pour des périodes de temps variables en mettant en œuvre différentes proportions de métaborate de baryum et d'oxyde de magnésium.

Tableau 1

| Proportion en poids Métaborate baryum/ Oxyde Magnésium | Viscosité (Pa.s) | | | | | | |
|---|---|---|---|---|---|---|---|
| | $T_0$ | 30 minutes | 1 heure | 2 heures | 3 heures | 1 jour | 2 jours |
| 35/65 | 1 200 | >500 000 | | | | | |
| 50/50 | 120 | 5 000 | >500 000 | | | | |
| 65/35 | 100 | 1 900 | 3 000 | 30 000 | | >300 000 | |
| 80/20 | 20 | 80 | 150 | | | 7 000 | 8 000 |

EXEMPLE 4

L'exemple 1 est répété en remplaçant le métaborate de baryum par du métaborate de lithium et de calcium, mais en mettant en œuvre 26,67 parties du catalyseur utilisé dans l'exemple 2.

Le tableau 2 donne les résultats obtenus.

Tableau 2

| Additif | Viscosité (Pa.s.) | | | | | |
|---|---|---|---|---|---|---|
| | $T_0$ | 30 minutes | 1 heure | 2 heures | 3 heures | 1 jour |
| Métabarate de lithium | 6 | 22 | 70 | 210 | 300 | 130 |
| Métabarate de calcium | 50 | 540 | 1040 | 5000 | | 5020 |

EXEMPLE 5

On met en œuvre 100 parties d'une résine phénolique qui présente les caractéristiques suivantes:

– Rapport molaire F/P: 1,5 Extrait sec: 80%, pic exothermique: 110°C 130 parties d'hydrate d'alumine comme charge On ajoute ensuite un mélange préparé à partir de 13,3 parties de métaborate de baryum et de 26,67 parties d'un catalyseur constitué d'un mélange de méthanol et d'acide paratoluène-sulfonique fabriqué à partir d'une mole de méthanol et d'une mole d'acide paratoluène-sulfonique.

La viscosité initiale est de 13 Pa.s. Elle évolue ensuite de la façon suivante:

– Après une journée 100 000 Pa.s
– Après 5 jours 200 000 Pa.s
– Après 10 jours 200 000 Pa.s

– On prépare à partir de cette composition un préimprégné à partir de 70 parties de la composition et 30 parties de fils de verre coupés.

Le préimprégné obtenu a un poids de 3300 g/m².

Ce produit peut être stocké pendant 3 mois à la température ambiante.

Il est ensuite moulé à une pression de 100 bars à une température de 145°C pendant 90 secondes. On obtient un produit après moulage qui présente une épaisseur de 3 mm.

Il présente les caractéristiques suivantes:

– Module en flexion: 9000 N/mm² (Norme NFT 51 001)
– Résistance en flexion: 1800 N/mm² (Norme NFT 51 001)
– Indice d'oxygène: 90% (Norme NFT 51 071)
– Epiradiateur: classement M1 (Norme NFP 92 501).

EXEMPLE 6

L'exemple 2 est répété mais en remplaçant l'oxyde de magnésium par 6,9 parties de métaborate de baryum et en mettant en œuvre la même quantité du même catalyseur.

La viscosité évolue de la façon suivante:
– Viscosité initiale: 1,6 Pa.s
– Viscosité après 30 minutes: 11 Pa.s
– Après 60 minutes: 11 Pa.s
– Après 40 heures: 20 Pa.s

EXEMPLE 7

L'exemple 2 est répété en mettant en œuvre 20 parties de métaborate de baryum. Les valeurs de la viscosité sont les suivantes:
– Viscosité initiale 15 Pa.s
– Viscosité après 10 minutes: 15 000 Pa.s
– Viscosité après 20 minutes: 60 000 Pa.s
– Viscosité après 30 minutes supérieure à 200 000 Pa.s

EXEMPLE 8

L'exemple 6 est répété en mettant en œuvre une résine qui présente un rapport molaire F/P = 1,2, une viscosité de 0,5 Pa.s et une réactivité de 80°C.

A cette résine on ajoute 40 parties d'un mélangeur constitué de 100 parties d'un catalyseur utilisé dans l'exemple 2 et 40 parties de métaborate de baryum. La viscosité évolue de la façon suivante
– Viscosité initiale: 20 Pa.s
– Viscosité après 1 jour: 4000 Pa.s
– Viscosité après 4 jours: 6500 Pa.s
– Viscosité après 6 jours: 8000 Pa.s

EXEMPLE 9

L'exemple 8 est répété mais en utilisant une résine qui présente les caractéristiques suivantes:
– Rapport molaire F/P = 2,5, une viscosité de 0,5 Pa.s et une réactivité de 80°C.

L'évolution de la viscosité est la suivante:
– Viscosité initiale: 28 Pa.s
– Viscosité après 1 jour: 4800 Pa.s
– Viscosité après 4 jours: 5000 Pa.s
– Viscosité après 6 jours: 10 000 Pa.s

**Revendications**

1. Compositions de résines phénoliques convenant pour la fabrication des mats préimprégnés phénoliques selon lesquelles les compositions utilisées pour l'imprégnation des mats de fils sont constituées de résines formo-phénoliques du type résols, de charges, de pigments et d'agents durcisseurs, caractérisés en ce que ces compositions contiennent un additif constitué d'au moins 20% en poids par rapport au poids total de l'additif, d'un métaborate alcalin ou alcalino-terreux, l'additif étant mis en œuvre en quantité au moins égale à 5% et au plus égale à 60% en poids par rapport au poids de la solution de résine phénolique.

2. Compositions selon 1 caractérisées en ce que le métaborate alcalin ou alcalino-terreux est mis en œuvre avec un oxyde alcalino-terreux, cet oxyde étant utilisé en quantité au plus égale à 80% par rapport au poids total de l'additif.

3. Compositions selon 1 à 2 caractérisées en ce que l'additif est mis en œuvre en quantité comprise entre 5 et 40% en poids par rapport au poids de la solution de résine phénolique.

4. Compositions selon 1 à 3 caractérisées en ce que le métaborate alcalin ou alcalino-terreux est choisi de préférence parmi le métaborate de lithium, de calcium ou de baryum.

**Claims**

1. Phenolic resin compositions suitable for the manufacture of phenolic prepreg mats, according to which the compositions employed for impregnating the fibre mats consist of phenolformaldehyde resins of the resole type, fillers, pigments and hardening agents, characterized in that these compositions contain an additive consisting of at least 20% by weight of an alkali or alkaline-earth metal metaborate relative to the total weight of the additive, the additive being used in a quantity equal to at least 5% and not exceeding 60% by weight relative to the weight of the solution of phenolic resin.

2. Compositions according to 1, characterized in that the alkali or alkaline-earth metal metaborate is used with an alkaline-earth metal oxide, this oxide being used in a quantity not exceeding 80% relative to the total weight of the additive.

3. Compositions according to 1 to 2, characterized in that the additive is used in a quantity of between 5 and 40% by weight relative to the weight of the solution of phenolic resin.

4. Compositions according to 1 to 3, characterized in that the alkali or alkaline-earth metal metaborate is preferably chosen from lithium, calcium or barium metaborate.

**Patentansprüche**

1. Phenolharzzusammensetzungen, die sich für die Herstellung vorimprägnierter Phenolharzmatten eignen, bei denen die für die Imprägnierung der Fasermatten verwendeten Zusammensetzungen von Phenolformolharzen des Resoltyps, Füllstoffen, Pigmenten und Härtern gebildet wird, dadurch gekennzeichnet, daß die Zusammensetzungen ein Zusatzmittel enthalten, das aus mindestens 20 Gew.-%, bezogen auf das Gesamtgewicht des Zusatzmittels, eines Alkali- oder Erdalkalimetaborats gebildet ist, wobei das Zusatzmittel in einer Menge von mindestens 5 Gew.-% und höchstens 60 Gew.-%, bezogen auf das Gewicht der Phenolharzlösung, eingesetzt ist.

2. Zusammensetzungen nach Anspruch 1, dadurch gekennzeichnet, daß das Alkali- oder Erdalkalimetaborat zusammen mit einem Erdalkalioxid eingesetzt ist, wobei dieses Oxid in einer Menge von höchstens 80 Gew.-%, bezogen auf das Gesamtgewicht des Zusatzmittels, verwendet ist.

3. Zusammensetzungen nach den Ansprüchen 1 und 2, dadurch gekennzeichnet, daß das Zusatzmittel in einer Menge zwischen 5 und 40 Gew.-%, bezogen auf das Gewicht der Phenolharzlösung, eingesetzt ist.

4. Zusammensetzungen nach den Ansprüchen 1 bis 3, dadurch gekennzeichnet, daß das Alkali- oder Erdalkalimetaborat vorzugsweise ausgewählt ist aus den Lithium-, Calcium- und Bariummetaboraten.